# EUROPÄISCHE PATENTSCHRIFT

(11) **EP 0 627 876 B1**
(45) Veröffentlichungstag und Bekanntmachung des Hinweises auf die Patenterteilung: **28.02.1996**
(21) Anmeldenummer: 93108782.9
(22) Anmeldetag: 01.06.1993
(51) Int. Cl.: H05K 9/00

(54) **Verfahren zur Herstellung einer elektromagnetisch dichten Halterung von zwei metallischen Bauteilen, und abgeschirmter Baugruppenträger mit derartigen Bauteilen**
Manufactoring method of an electromagnetically sealed support of two metallic components and a shielded circuit board with such components
Procédé de production d'un support à imperméabilité électromagnétique de deux composants métalliques et plaquette à circuits blindée munie de tels composants

(43) Veröffentlichungstag der Anmeldung: 07.12.1994
(73) Patentinhaber: SIEMENS AKTIENGESELLSCHAFT, D-80333 München (DE)
(72) Erfinder: Behrens, Ralf, Dipl.-Ing. (FH), W-8500 Nürnberg (DE); Meier, Norbert, Dipl.-Ing., W-8439 Postbauer-Heng (DE); Schaffer, Kurt-Michael, W-8501 Eckental (DE)

(56) Entgegenhaltungen:
- EP-A- 0 315 798
- US-A- 4 800 463
- MOTOROLA TECHNICAL DEVELOPMENTS Bd. 17 , Dezember 1992 , SCHAUMBURG, ILLINOIS US Seiten 85 - 86 XP000329500 MALCOLM PERRY 'METHOD OF SECURING PANELS TO EMI CABINETS'

## Beschreibung

Die Erfindung betrifft ein Verfahren zur elektromagnetisch dichten Halterung von Zwei metallischen Bauteilen, und abgeschirmte Baugruppenträger zur Halterung von elektronischen Baugruppen.

In dünnwandige, bevorzugt aus Aluminium bestehende Bleche oder Profile können sogenannte "Prägenoppen" eingedrückt werden. Bei dieser Druckumformung wird die Oberfläche des dünnwandigen Bleches bzw. Profiles beidseitig verändert, indem ein z.B. zylindrischer Prägestempel in das Blech eingedrückt wird. Hierdurch entsteht in der dem Stempel zugewandten Oberfläche des Bleches eine zylinderförmige Vertiefung, während auf der gegenüberliegenden Oberseite der Werkstoff sich noppenartig auswölbt. Bei richtiger Abstimmung von Stempeldurchmesser und Eindrücktiefe auf Stärke und Art des jeweiligen Bleches können Noppen mit einer nahezu idealen zylindrischen Form ausgeprägt werden. Der zylindrische Noppenmantel steht somit annähernd senkrecht zur Blechoberfläche. Dünnwandige Aluminiumbleche eignen sich besonders zum Eindrücken derartiger, einseitig hervorstehender Prägenoppen.

Es ist bekannt, Prägenoppen der oben beschriebenen Art in dünnwandige, aus Aluminium bestehende Seitenteile und Zwischenwände von Baugruppenträgern einzubringen. Derartige Baugruppenträger sind beispielsweise in sogenannter "zölliger" (z.B. 19-Zoll-Bauweise) bzw. in metrischer Rasterung aufgebaut. Sie dienen zur ordnungsgemäßen Aufnahme von elektrischen bzw. elektronischen Bauteilen und Baugruppen, insbesondere von Leiterplatten unterschiedlichster Art, Stromversorgungen und dergleichen. Derartige "Flachbaugruppen" werden senkrecht stehend und dicht aneinander liegend in die speziell aufgebauten und dimensionierten Baugruppenträger eingeschoben. Die in Seitenteilen und Zwischenwänden derartiger Baugruppenträger eingebrachten Prägenoppen dienen dabei als Positioniermittel z.B. für Verbindungsschienen, welche im Baugruppenträger quer verlaufend stirnseitig mit den Seitenteilen bzw. Zwischenwänden verschraubbar sind.

Bei Baugruppenträgern zur Aufnahme von elektronischen Baugruppen besteht häufig die Anforderung, daß diese im Rahmen der sogenannten "elektromagnetischen Verträglichkeit" (EMV) derart ausgeführt sind, daß elektromagnetische Störeinflüsse in einem möglichst großen Frequenzbereich abgeschirmt werden. Alle Bauteile eines Baugruppenträgers müssen in einem solchen Fall nicht nur elektrisch leitend miteinander verbunden sein. Vielmehr müssen alle Verbindungen zwischen den Bauteilen derart ausgeführt sein, daß elektromagnetische Störstrahlung auch höherer Frequenz die Verbindungsstellen nicht durchdringen kann.

Zur elektromagnetischen Abdichtung derartiger Übergangsstellen ist es bekannt, zusätzliche, häufig aus Spezialmaterial bestehende Bauteile zu verwenden. So werden z.B. Kontaktfederstreifen aus einer Kupfer-Berillium-Legierung zur elektromagnetischen Abdichtung in die Stoßbereiche z.B. zwischen Verbindungsschienen und Abdeckblechen eingelegt. In anderen Fällen werden z.B. spezielle schlauchartige Gewebe, welche aus feinsten Drähten gewebt sind, als Einlagen zwischen Schienen und aufzuschraubenden Abdeckblechen verwendet.

Derartige Systeme zur elektromagnetischen Abdichtung der Kontaktbereiche zwischen zwei metallischen Bauteilen, insbesondere in Baugruppenträgern, weisen nicht nur den Nachteil auf, daß zusätzliche, speziell ausgebildete Kontaktmittel benötigt werden. Vielmehr wird bei der Montage die genaue gegenseitige Zuordnung der miteinander zu fixierenden Bauteile aufgrund der Zwischenlage der Kontaktmittel erschwert. Desweiteren müssen besondere Maßnahmen getroffen werden, daß trotz der Zwischenlage von Kontaktmitteln die mechanische Stabilität der Verbindung der Bauteile gewährleistet ist.

Der Erfindung liegt die Aufgabe zugrunde, eine elektromagnetisch dichte Fixierung von zwei metallischen Bauteilen, insbesondere an einem abgeschirmten Träger zur Halterung von elektronischen Baugruppen, auf eine einfachere Weise als bisher zu ermöglichen.

Aus dem "Buch" Bauelemente der Feinmechanik" von O. Richter und R. v. Voss, VEB Verlag Technik Berlin, 8. Auflage 1959, sind gemäß dem dortigen Kapitel 285 auf Seite 161 ff Sickverbindungen bekannt. Sickverbindungen sind Verbindungen zweier ineinandergesteckter, meist zylindrischer Werkstücke, wobei die Verbindung durch Eindrücken einer Sicke in das eine Werkstück gefügt wird. Das durch den Sickenwulst in das andere Teil eingreifende Werkstück muß stets aus weichem, metallischem Werkstoff bestehen. Das von dem Eingriffsteil gehaltene Werkstück dagegen kann aus einem Werkstoff beliebiger Art hergestellt sein.

Aus dem Deutschen Gebrauchsmuster mit dem Aktenzeichen G 87 14 497.2 ist es bekannt, ein Etagenschirmblech für Baugruppenträger elektrisch leitend an einer Tragschiene des Baugruppenträgers mit Hilfe von V-förmigen Befestigungsfedern anzubringen. Das Etagenschirmblech weist hierzu an den Seiten des Auflagebereiches Reihen von rechteckförmigen Löchern auf. Durch diese greifen die Schenkel der V-förmigen Befestigungsfedern zur Verklinkung mit der Tragschiene hindurch.

Die Aufgabe wird durch die Verfahren gemäß den Patentansprüchen 1 und 6 gelöst. Vorteilhafte, weitere Ausführungsformen der Erfindung sind in den Unteransprüchen 2 bis 5 und 7,8 enthalten. Gemäß den Ansprüchen 9 und 10 betrifft die Erfindung auch einen abgeschirmten Baugruppenträger zur Halterung von elektronischen Baugruppen, bei dem Bauteile desselben erfindungsgemäß durch Prägenoppen elektromagnetisch dicht aneinander fixiert sind.

Die Erfindung wird desweiteren anhand der in den nachfolgend kurz angeführten Figuren dargestellten bevorzugten Ausführungsbeispielen näher erläutert. Dabei zeigen:
- FIG 1a,1b: beispielhaft eine Schiene und ein Blech als gegenseitig elektromagnetisch dicht zu verbindende Bauteile vor und nach der Fixierung, wobei die Prägenoppen gemäß einer ersten Ausführungsform der Erfindung nach der Verbindung beider Bauteile in die Oberseite des ersten, schienenartigen Bauteiles eingebracht werden,
- FIG 2a,2b: eine erweiterte Ausführung des Beispieles von FIG 1a,1b, wobei die Schiene zusätzlich einen Längsschlitz im Inneren der Nut aufweist,
- FIG 3a,3b: eine erweiterte Ausführung des Beispieles von FIG 1a,1b, wobei das Blech zusätzlich Senkpunkte aufweist,
- FIG 4a,4b: eine erweiterte Ausführung des Beispieles von FIG 1a,1b, wobei die Schiene zusätzlich einen Längssteg im Inneren der Nut und das Blech zusätzlich einen Längsschlitz aufweisen,
- FIG 5a,5b: wiederum beispielhaft eine Schiene und ein Blech als gegenseitig elektromagnetisch dicht zu verbindende Bauteile vor und nach der Fixierung, wobei die Prägenoppen gemäß einer zweiten Ausführungsform der Erfindung vor der Verbindung der beiden Bauteile in die Oberseite des zweiten, blechartigen Bauteiles hervorstehend eingebracht sind,
- FIG 6a: eine Prägenoppe mit einer herkömmlichen, annähernd zylindrischen Form,
- FIG 6b,6c: bevorzugte Prägenoppen mit einer zusätzlichen Kontaktspitze am Kopfbereich, und
- FIG 6d,6e: bevorzugte Prägenoppen mit abgerundeten bzw. abgeschrägten Kopfbereichen.

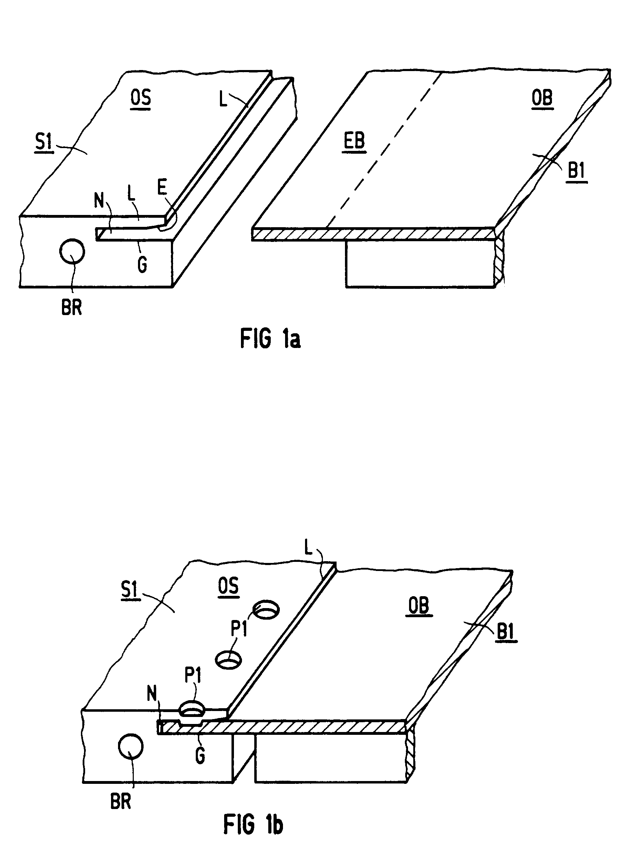

In FIG 1a ist die Grundform der beiden metallischen Bauteile dargestellt, welche gemäß der Erfindung unter Verwendung von Prägenoppen elektromagnetisch dicht miteinander fixiert werden. Das erste Bauteil S1 weist dabei am Rand von einer Oberseite OS eine längsverlaufende Nut N auf, welche durch eine Lamelle L als Verlängerung der Oberseite OS des Bauteiles S1 zumindest teilweise abgedeckt ist. Die Lamelle ist relativ dünnwandig und bevorzugt bis zu einem gewissen Grad elastisch. Im Beispiel der FIG 1a hat dieses erste Bauteil die Form einer querverlaufenden Tragschiene, welche z.B. über eine Längsbohrung BR an der Stirnseite senkrecht stehend auf der Oberfläche z.B. eines Seitenteiles bzw. einer Zwischenwand eines Baugruppenträgers aufschraubbar ist. Selbstverständlich kann dieses erste Bauteil auch eine beliebige andere Form aufweisen. Es muß lediglich in einem Rand-, Kanten- bzw. Absatzbereich über eine Nut verfügen, welche im Prinzip gemäß der Darstellung von FIG 1a durch eine lamellenartige Verlängerung L abgedeckt ist. Die Nut mit der abdeckenden Lamelle kann auch unter einem Winkel auf einer Außenseite des Körpers des ersten Bauteiles angebracht sein.

FIG 1a zeigt weiterhin die Grundform des zweiten Bauteiles, welches unter der erfindungsgemäßen Verwendung von Prägenoppen elektromagnetisch dicht und ausreichend mechanisch stabil mit dem ersten Bauteil fixiert werden soll. Das zweite Bauteil B1 weist dabei zumindest einen messerartigen Einsteckbereich EB auf, welcher in die Nut N des ersten Bauteiles S1 einsteckbar ist. Im Beispiel der FIG la weist das zweite Bauteil B1 die Form eines Abdeckbleches z.B. für eine Außenseite eines Baugruppenträgers auf, welches in die Nut N des als eine Tragschiene dienenden ersten Bauteiles S1 einschiebbar ist. In diesem Fall wirkt der in FIG 1a strichliert markierte Randbereich der Oberseite OB des Abdeckbleches als messerartiger Einsteckbereich EB zum Einstecken in die Nut N von S1. Selbstverständlich kann auch in diesem Fall das zweite Bauteil eine beliebig andere Form aufweisen, solange es zumindest über einen messerartigen, bevorzugt blechstreifenartigen Einsteckbereich EB verfügt.

In FIG 1b ist eine erste Ausführungsform für die erfindungsgemäße, elektromagnetisch dichte Fixierung der beiden Bauteile S1 und B1 von FIG 1a dargestellt. Hierzu wird zunächst der Einsteckbereich EB des zweiten Bauteiles B1 in die Nut N des ersten Bauteiles S1 eingesteckt. Anschließend werden in die Oberfläche OS des ersten Bauteiles S1 im Bereich der Lamelle L Prägenoppen P1 eingebracht. FIG 1b zeigt beispielhaft drei, in einer Reihe entlang der Längskante von L eingebrachte Noppen 1. An der vorderen, im Schnitt dargestellten Prägenoppe ist zu erkennen, daß diese sich im Einsteckbereich EB in die Oberfläche OB des zweiten Bauteiles B1 eingesenkt hat. Hierdurch wird auf einfache Weise eine sowohl mechanisch feste als auch elektromagnetisch dichte gegenseitige Fixierung der beiden Bauteile S1 und B1 bewirkt, ohne daß irgendwelche zusätzlichen Elemente wie z.B. Kontaktfederstreifen z.B. in das Innere der Nut N eingelegt werden müßten.

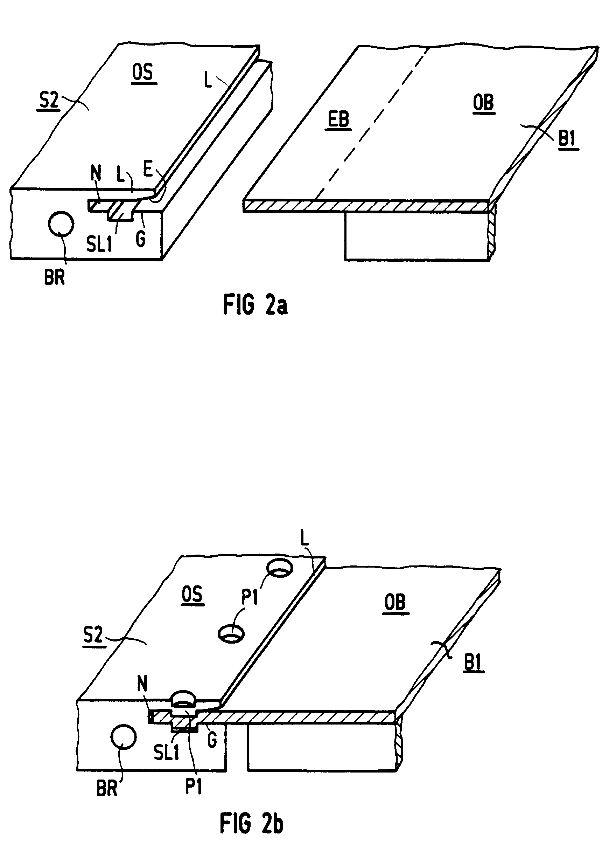

In den Figuren 2a,2b ist eine erweiterte Ausführung dargestellt. Dabei weist das erste Bauteil S2 einen zusätzlichen Längsschlitz SL1 auf, welcher sich unterhalb der Lamelle L im gegenüberliegenden Grund der Nut N befindet. Zur Fixierung der beiden Bauteile wird zunächst das zweite Bauteil B2 wiederum über den Einsteckbereich in die Nut N eingesteckt. Gemäß der Darstellung von FIG 2b werden anschließend die Prägenoppen P1 erfindungsgemäß unmittelbar über dem Längsschlitz L1 liegend im Bereich der Lamelle L in die Oberfläche OS des ersten Bauteiles S2 eingedrückt. Wie an der Schnittdarstellung der vorderen von den beispielhaft drei Prägenoppen in FIG 2b zu erkennen ist, bewirkt das Eindrücken der Prägenoppen in diesem Fall eine lokale Einsenkung von Material aus dem Einsteckbereich EB des zweiten Bauteiles B1 in den darunter befindlichen Längsschlitz SL1. Mit dieser Ausführungsform kann die elektromagnetische Dichtigkeit und die mechanische Stabilität der gegenseitigen Verbindung der Bauteile S2 und B1 weiter verbessert werden.

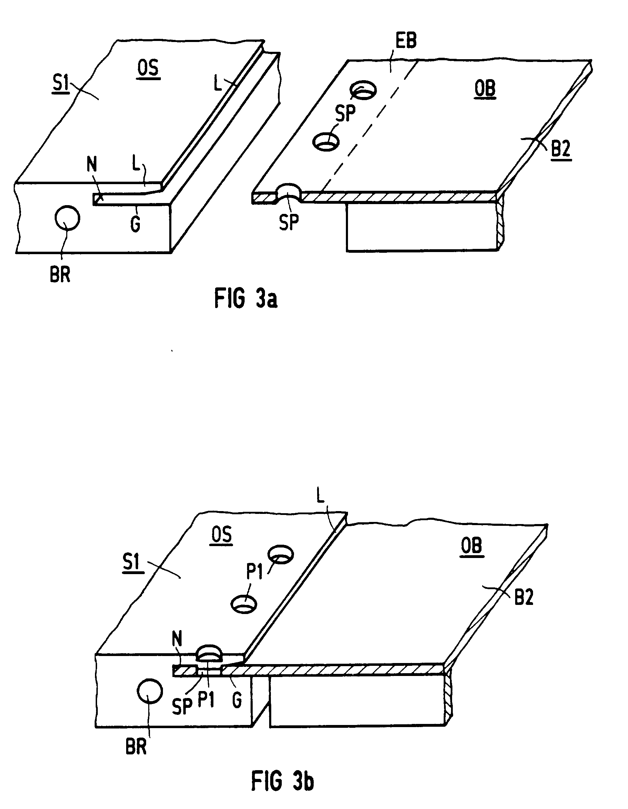

Bei den in den Figuren 3a,3b beispielhaft dargestellten erweiterten Ausführungen weist das zweite Bauteil B2 auf der Oberfläche OB im Bereich des messerartigen Einsteckbereiches EB Senkpunkte SP auf, welche bevorzugt in einer Reihe entlang der Längskante des Einsteckbereiches angeordnet sind. Diese Senkpunkte können in Form von Einsenkungen, Mulden, durchgehenden Bohrungen, Stanzungen oder dergleichen ausgeführt sein. Im Beispiel der FIG 3a haben die Senkpunkte die Form von Bohrungen, welche die Oberfläche OB des zweiten Bauteiles B2 durchsetzen. Zur gegenseitigen Fixierung der Bauteile S1 und B3 wird wiederum der Einsteckbereich EB von B2 in die Nut N von S1 eingesteckt. Gemäß der Darstellung von FIG 3b befinden sich die Senkpunkte SP nun im Inneren der Nut und werden durch die Lamelle L abgedeckt. Werden auch hier die Prägenoppen P1 wieder jeweils unmittelbar über den einzelnen Senkpunkten SP liegend im Bereich der Lamelle L in die Oberfläche OS des ersten Bauteiles S1 eingebracht, so kann sich die jeweilige Noppe beim Prägevorgang in den darunter befindlichen Senkpunkt eindrücken. Auch hiermit kann die mechanische Stabilität und die elektromagnetische Dichtigkeit der Verbindung der Bauteile S1 und B2 weiter verbessert werden.

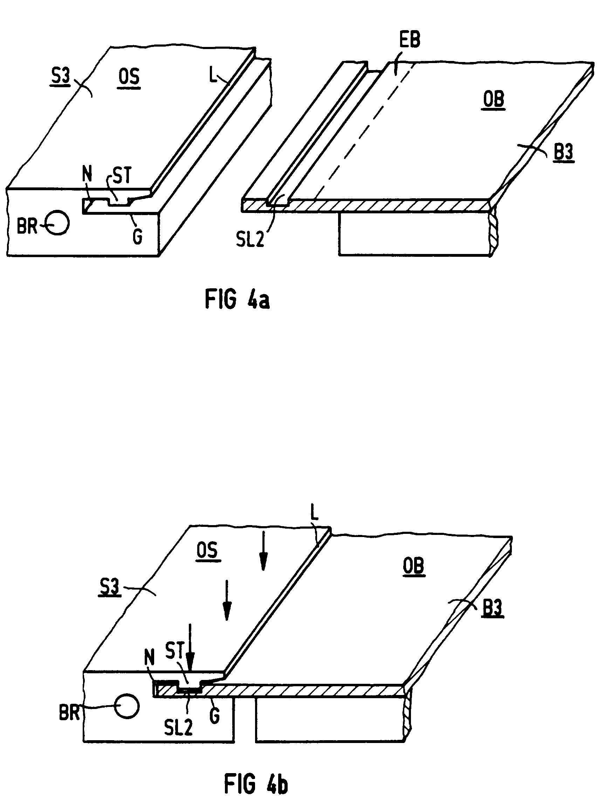

In den Figuren 4a,4b sind weitere, mögliche Ergänzungen dargestellt. So weist zum einen beim ersten Bauteil S3 die Lamelle L auf der Innenseite der Nut N einen Längssteg ST auf. Desweiteren ist beim zweiten Bauteil B3 auf der Oberfläche OB des Einschubbereiches EB ein längslaufender Senkschlitz SL2 eingebracht. Nach Einstecken des Einsteckbereiches EB von B3 in die Nut N von S3 kommt gemäß der Darstellung von FIG 4b der Senkschlitz SL2 annähernd unmittelbar unter dem Längssteg ST zu liegen. Auch bei dieser Ausführung werden die erfindungsgemäßen Prägenoppen P1 unmittelbar über dem Längssteg ST bzw. dem Senkschlitz SL2 liegend im Bereich der Lamelle L in die Oberfläche OB des ersten Bauteiles S3 eingedrückt. Dabei wird wiederum ein Teil des Längssteges ST entweder unmittelbar in die darunter liegende Oberfläche OB von B3 oder einen darunter befindlichen längsverlaufenden Senkschlitz SL2 in der Oberfläche OB des zweiten Bauteiles B3 eingedrückt. Auch hiermit kann die mechanische Stabilität und die Dichtigkeit des Verbindungsbereiches zwischen den Bauteilen S3 und B3 verbessert werden.

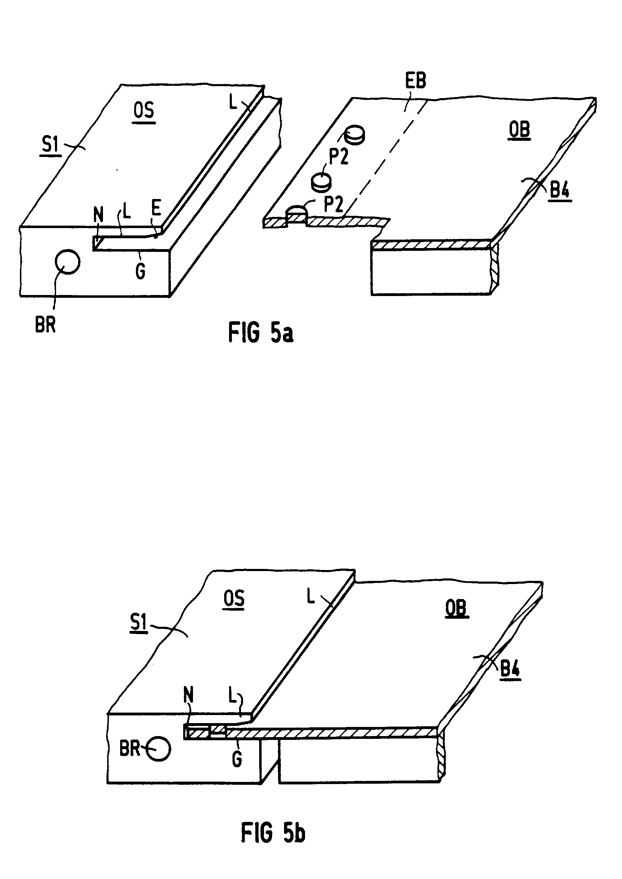

Die Figuren 5a, 5b zeigen eine zweite vorteilhafte Ausführungsform der erfindungsgemäßen Verwendung von Prägenoppen zur gegenseitigen elektromagnetisch dichten Fixierung zweier metallischer Bauteile. Auch hier weist das erste Bauteil S1 wiederum bevorzugt am Rand von einer Oberseite OS eine Nut N auf. Im Gegensatz zu den Darstellungen der Figuren 1a, 1b bis 4a, 4b ist es in diesem Fall aber nicht unbedingt notwendig, daß die Nut durch eine Lamelle L abgedeckt ist. Vielmehr kann sich die Nut auch an einer beliebigen Stelle der Oberseite OS von S1 befinden und z.B. senkrecht zur Oberfläche OS in den Körper des ersten Bauteiles S1 eingeschnitten sein. Erfindungsgemäß sind in diesem Fall aber in den messerartigen Einsteckbereich ES des zweiten Bauteiles B4 Prägenoppen P2 hervorstehend eingebracht.

Im Beispiel der FIG 5a sind diese Prägenoppen P2 wiederum in einer Reihe entlang der Kante des Einsteckbereiches EB angeordnet. Bei dieser Ausführung wird somit der Einsteckbereich des zweiten Bauteiles vor der Verbindung mit dem ersten Bauteil mit Prägenoppen versehen. Die eigentliche Fixierung der beiden Bauteile S1, B4 wird dann nach Einstecken des Einsteckbereiches EB des zweiten Bauteiles B4 in die Nut N des ersten Bauteiles S1 durch Verklemmung der Prägenoppen P2 im Inneren der Nut N bewirkt. Diese Ausführungsform der Erfindung hat den Vorteil, daß nach Einstecken des zweiten Bauteiles in die Nut des ersten Bauteiles keine weiteren Fertigungsschritte notwendig sind. Vielmehr können beide Bauteile komplett vorgefertigt und anschließend durch einfaches Einstecken, Einpressen bzw. Einschlagen des mit Prägenoppen versehenen Einsteckbereiches EB in die Nut N elektromagnetisch dicht gegenseitig fixiert werden. Gemäß der Darstellung in FIG 5b reiben sich die Prägenoppen P2 bei diesem Einsteckvorgang bis zu einem gewissen Grad in den Werkstoff der gegenüberliegenden Nutseite ein. Im Beispiel der FIG 5b wird diese Nutseite durch die Innenseite der Lamelle L gebildet. Diese Ausführung hat zudem den Vorteil, daß die beiden Bauteile S1 und B4 unter Umständen wieder voneinander lösbar sind.

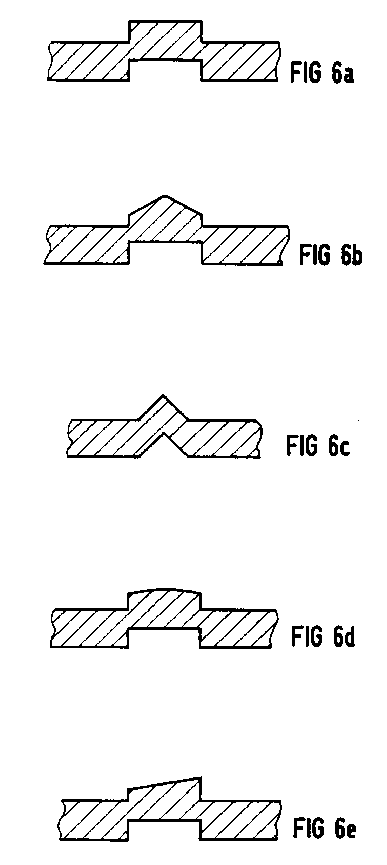

In den Figuren 6a bis 6e sind schließlich mögliche Prägenoppenformen dargestellt. Dabei zeigt FIG 6a eine Prägenoppe mit herkömmlicher, annähernd zylindrischer Form. Diese ist durch alleinige Einwirkung eines zylindrischen Prägestempels auf die Oberfläche eines dünnwandigen, bevorzugt aus Aluminium bestehenden Bleches erreichbar. Insbesondere ist es nicht notwendig, auf der Noppenseite beim Prägevorgang ein Gesenk vorzusehen, welches seinerseits eine zylindrische Mulde aufweist, in welche die Noppe eingeprägt wird.

In den Figuren 6b bis 6e sind schließlich bevorzugte, weitere Prägenoppen dargestellt. Dabei weisen die Prägenoppen der Figuren 6b,6c im Kopfbereich zusätzliche Kontaktspitzen auf. Während die Prägenoppenform von FIG 6b unter Zuhilfenahme eines gegenüberliegenden, entsprechend ausgeformten Gesenkes erzeugt werden kann, entsteht die Prägenoppe mit der in FIG 6c dargestellten Form allein durch Einwirkung eines Prägestempels mit kegelartiger Spitze. Die Prägenoppenformen der Figuren 6b,6c sind insbesondere bei der in den Figuren 5a,5b dargestellten Ausführungsform der Erfindung einsetzbar. Die elektrische Kontaktierung und mechanische Verklemmung der Prägenoppen im Einsteckbereich EB wird beim Eintreiben des zweiten Bauteiles B4 in die Nut des ersten Bauteiles S1 durch die Kontaktspitzen im Kopfbereich der Prägenoppen weiter verbessert.

Schließlich weisen die in FIG 6d,6e dargestellten Prägenoppen im Gegensatz zu den Ausführungen in den Figuren 6b,6c abgerundete bzw. abgeschrägte Kopfbereiche auf. Auch diese Prägenoppenformen sind besonders bei der zweiten Ausführungsform der Erfindung gemäß den Darstellungen in den Figuren 5a,5b einsetzbar. Weist in diesem Fall die Nut N am Rand von der Oberseite OS des ersten Bauteiles S1 eine Verengung bzw. im Vergleich zum Nutinneren eine geringere Breite am Außenrand auf, so kann das Eintreiben des Einsteckbereiches EB des zweiten Bauteiles B4 durch Prägenoppen mit abgerundeten bzw. abgeschrägtem Kopfbereich erleichtert werden. Ferner kann die Nut in diesem Fall unmittelbar am Rand von der Oberseite OS des ersten Bauteiles S1 mindestens eine Einlaufschräge E aufweisen.

## Patentansprüche

1. Verfahren zur Herstellung einer elektromagnetisch dichten Halterung von zwei metallischen Bauteilen (S1,S2,S3 mit B1,B2,B3), insbesondere zur Halterung eines Abdeckbleches an einer Tragschiene eines abgeschirmten Baugruppenträgers für elektronische Baugruppen, wobei
a) das erste Bauteil (S1,S2 bzw. S3) am Rand von einer Oberseite (OS) eine Nut (N) aufweist, welche durch eine Lamelle (L) bevorzugt als Verlängerung der Oberseite (OS) des Bauteiles (S1,S2 bzw. S3) abgedeckt ist,
b) das zweite Bauteil (B1,B2 bzw. B3) einen messerartigen Einsteckbereich (EB) aufweist, und
c) nach Einstecken des Einsteckbereiches (EB) des zweiten Bauteiles (B1,B2 bzw. B3) in die Nut (N) Prägenoppen (P1) im Bereich der Lamelle (L) in die Oberfläche (OS) des ersten Bauteiles (S1,S2 bzw. S3) eingebracht werden. (FIG 1a bis FIG 4b)

2. Verfahren nach Anspruch 1, wobei beim ersten Bauteil (53) die Lamelle (L) auf der Innenseite der Nut (N) einen Längssteg (ST) aufweist, und die Prägenoppen (P1) unmittelbar über dem Längssteg (ST) liegend im Bereich der Lamelle (L) in die Oberfläche (OB) des ersten Bauteiles (53) eingebracht werden. (FIG 4a,4b)

3. Verfahren nach Anspruch 1 oder 2, wobei das zweite Bauteil (B2) auf der Oberfläche (OB) des Einsteckbereiches (EB) Senkpunkte (SP) aufweist, insbesondere Mulden, Bohrungen oder Stanzungen, und die Prägenoppen (P1) jeweils unmittelbar über den einzelnen Senkpunkten (SP) liegend im Bereich der Lamelle (L) in die Oberfläche (OS) des ersten Bauteiles (S1,S2,S3) eingebracht werden. (FIG 3a,3b)

4. Verfahren nach Anspruch 1 oder 2, wobei das zweite Bauteil (B3) auf der Oberfläche (OB) des Einsteckbereiches (EB) einen längslaufenden Senkschlitz (SL2) aufweist, und die Prägenoppen (P1) unmittelbar über dem Senkschlitz (SL2) liegend im Bereich der Lamelle (L) in die Oberfläche (OB) des ersten Bauteiles (S1,S2,S3) eingebracht werden. (FIG 4a,4b).

5. Verfahren nach Anspruch 1, wobei beim ersten Bauteil (S2) der der Nutinnenseite unterhalb der Lamelle (L) gegenüberliegende Grund der Nut (N) einen Längsschlitz (SL1) aufweist, und die Prägenoppen (P1) unmittelbar über dem Längsschlitz (SL1) liegend im Bereich der Lamelle (L) in die Oberfläche (OS) des ersten Bauteiles (S2) eingebracht werden. (FIG 2a,2b)

6. Verfahren zur Herstellung einer elektromagnetisch dichten Halterung von zwei metallischen Bauteilen (S1,B4), insbesondere zur Halterung eines Abdeckbleches an einer Tragschiene eines abgeschirmten Baugruppen-Trägers für elektronische Baugruppen, wobei
a) das erste Bauteil (S1) an einer Oberseite (OS) eine Nut (N) aufweist,
b) das zweite Bauteil (B4) einen messerartigen Einsteckbereich (EB) aufweist, in den Prägenoppen (P2) hervorstehend eingebracht sind, und
c) die Fixierung der beiden Bauteile (S1,B4) nach Einstecken des Einsteckbereiches (EB) des zweiten Bauteiles (B4) in die Nut (N) des ersten Bauteiles (S1) durch Verklemmung der Prägenoppen (P2) im Inneren der Nut (N) bewirkt wird. (FIG 5a u. 5b)

7. Verfahren nach Anspruch 6, wobei die Nut (N) am Rand von der Oberseite (OS) des ersten Bauteiles (S1) eine Verengung bzw. eine geringere Breite als im Inneren aufweist.

8. Verfahren nach Anspruch 6 oder 7, wobei die Nut (N) unmittelbar am Rand von der Oberseite (OS) des ersten Bauteiles (S1) mindestens eine Einlaufschräge (E) aufweist.

9. Abgeschirmter Baugruppenträger zur Halterung von elektronischen Baugruppen, insbesondere von Leiterplatten, mit
a) einem ersten metallischen Bauteil (S1,S2 bzw. S3), insbesondere einer Tragschiene, welches am Rand von einer Oberseite (OS) eine Nut (N) aufweist, die durch eine Lamelle (L) bevorzugt als Verlängerung der Oberseite (OS) des Bauteiles (S1,S2 bzw. S3) abgedeckt ist, und
b) einen zweiten metallischen Bauteil (B1,B2 bzw. B3), insbesondere einem Abdeckblech, welches einen messerartigen Einsteckbereich (EB) aufweist, und wobei
c) die elektromagnetisch dichte Fixierung der beiden Bauteile (S1,S2 bzw. S3 mit B1,B2 bzw. B3) durch Prägenoppen (P1) bewirkt wird, welche nach Einstecken des Einsteckbereiches (EB) des zweiten Bauteiles (B1,B2 bzw. B3) in die Nut (N) im Bereich der Lamelle (L) in die Oberfläche (OS) des ersten Bauteiles (S1,S2 bzw. S3) eingebracht sind. (FIG 1a bis 4b)

10. Abgeschirmter Baugruppenträger zur Halterung von elektrischen Baugruppen, insbesondere von Leiterplatten, mit
a) einem ersten metallischen Bauteil (S1), insbesondere einer Tragschiene, welches an einer Oberseite eine Nut (N) aufweist, und
b) einem zweiten metallischen Bauteil (B4), insbesondere einem Abdeckblech, welches einen messerartigen Einsteckbereich (EB) mit hervorstehenden Prägenoppen aufweist, und
c) die elektromagnetisch dichte Fixierung der beiden Bauteile (S1,B4) nach Einstecken des Einsteckbereiches (EB) des zweiten Bauteiles (B4) in die Nut (N) des ersten Bauteiles (S1) durch Verklemmung der Prägenoppen (P2) im Inneren der Nut (N) bewirkt wird. (FIG 5a und 5b)

## Claims

1. A method for producing an electromagnetically sealed securing of two metallic components (S1, S2, S3 with B1, B2, B3), in particular for securing a cover plate to a support bar of a shielded assembly support for electronic assemblies, wherein
a) the first component (S1, S2 or S3) comprises a groove (N) at the edge of a surface (OS), which groove is covered by a leaf (L) preferably as a extension of the surface (OS) of the component (S1, S2 or S3),
b) the second component (B1, B2 or B3) comprises a blade-like insertion area (EB), and
c) after the insertion of the insertion area (EB) of the second component (B1, B2 or B3) into the groove (N), embossed nubs (P1) are formed in the surface (OS) of the first component (S1, S2 or S3) in the region of the leaf (L) (Figs. 1a to 4b).

2. A method according to claim 1, wherein, in the case of the first component (S3) the leaf (L) comprises a longitudinal web (ST) on the inside of the groove (N), and the embossed nubs (P1) are formed in the surface (OB) of the first component (S3) in the region of the leaf (L) directly above the longitudinal web (ST).

3. A method according to claim 1 or 2, wherein the second component (B2) comprises countersunk points (SP) on the surface (OB) of the insertion area (EB), more particularly hollows, bores or punched holes, and the embossed nubs (P1) are formed in the surface (OS) of the first component (S1, S2, S3) in the region of the leaf (L) directly above the individual countersunk points (SP) in each case. (Figs. 3a, 3b)

4. A method according to claim 1 or 2, wherein the second component (B3) comprises a longitudinally extending recessed slot (SL2) on the surface (OB) of the insertion area (EB), and the embossed nubs (P1) are formed in the surface (OB) of the first component (S1, S2, S3) in the region of the leaf (L) directly above the recessed slot (SL2). (Figs. 4a, 4b)

5. A method according to claim 1, wherein, in the case of the first component (S2) the base of the groove (N) lying opposite the groove inner side beneath the leaf (L) comprises a longitudinal slot (SL1), and the embossed nubs (P1) are formed in the surface (OS) of the first component (S2) in the region of the leaf (L) directly above the longitudinal slot (SL1).

6. A method for producing an electromagnetically sealed securing of two metallic components (S1, B4), in particular for securing a cover plate to a support bar of a shielded assembly support for electronic assemblies, wherein
a) the first component (S1) comprises a groove (N) on one surface (OS),
b) the second component (B4) comprises a blade-like insertion area (EB), in which embossed nubs (P2) are formed so as to project, and
c) the securing of the two components (S1, B4) is effected after the insertion of the insertion area (EB) of the second component (B4) into the groove (N) of the first component (S1) by wedging the embossed nubs (P2) within the groove (N). (Figs. 5a and 5b)

7. A method according to claim 6, the groove (N) comprising a constriction or a smaller width at the edge of the surface (OS) of the first component (S1) than at the groove interior.

8. A method according to claim 6 or 7, the groove (N) comprising at least one inlet slope (E) directly at the edge of the surface (OS) of the first component (S1).

9. A shielded assembly support for securing electronic components, in particular circuit boards, with
a) a first metallic component (S1, S2 or S3), in particular a support bar, which comprises a groove (N) at the edge of a surface (OS), which groove is covered by a leaf (L), preferably as an extension of the surface (OS) of the component (S1, S2 or S3), and
b) a second metallic component (B1, B2 or B3), in particular a cover plate, which comprises a blade-like insertion area (EB), and
c) the electromagnetically sealed securing of the two components (S1, S2 or S3 and B1, B2 or B3) is effected by embossed nubs (P1), which after the insertion of the insertion area (EB) of the second component (B1, B2, or B3) into the groove (N), are formed in the surface (OS) of the first component (S1, S2 or S3) in the region of the leaf (L). (Figs. 1a to 4b).

10. A shielded assembly support for securing electronic assemblies, in particular circuit boards, with
a) a first metallic component (S1), more particularly a support bar, which comprises a groove (N) on one surface, and
b) a second metallic component (B4), more particularly a cover plate, which comprises a blade-like insertion area (EB) with projecting embossed nubs, and
c) the electromagnetically sealed securing of the two components (S1, B4) is effected after the insertion of the insertion area (EB) of the second component (B4) into the groove (N) of the first component (S1) by wedging the embossed nubs (P2) within the groove (N). (Figs. 5a and 5b).

## Revendications

1. Procédé d'établissement d'une fixation, étanche du point de vue électromagnétique, entre deux composants métalliques (S1,S2,S3 avec B1,B2,B3), notamment pour la fixation d'une tôle de revêtement sur un rail de support d'un porte-modules blindé destiné à des modules électroniques, selon lequel
a) le premier composant (S1,S2 ou S3) comporte, au bord d'une face supérieure (OS), une rainure (N) qui est recouverte d'une lamelle (L) de préférence sous forme de prolongement de la face supérieure (OS) du composant (S1,S2 ou S3),
b) le second composant (B1,B2 ou B3) a une partie d'enfichage en forme de couteau (EB), et
c) après enfichage de la partie d'enfichage (EB) du second composant (B1,B2 ou B3) dans la rainure (N), on aménage des bossages refoulés par estampage (P1), dans la région de la lamelle (L), dans la surface (OS) du premier composant (S1,S2 ou S3). (Figure 1a à figure 4b).

2. Procédé suivant la revendication 1, selon lequel, dans le cas du premier composant (S3) la lamelle (L) comporte, sur le côté intérieur de la rainure (N), une barrette longitudinale (ST), et on aménage les bossages refoulés par estampage (P1) de manière qu'ils soient directement au-dessus de la barrette longitudinale (ST), dans la région de la lamelle (L), dans la surface (OB) du premier composant (53). (Figures 4a, 4b).

3. Procédé suivant la revendication 1 ou 2, selon lequel le second composant (B2) comporte, sur la surface supérieure (OB) de la zone d'enfichage (EB), des renfoncements (SP), notamment des cavités, des perçages, des découpes, et on aménage les bossages refoulés par estampage (P1) respectivement directement au-dessus de divers points de renfoncement (SP), au voisinage de la lamelle (L), dans la surface (OS) du premier composant (S1,S2,S3). (Figures 3a, 3b).

4. Procédé suivant la revendication 1 ou 2, selon lequel le second composant (B3) comporte, sur la surface (OB) de la partie d'enfichage (EB), une rainure longitudinale (SL2), et on aménage les bossages refoulés par estampage (P1) directement au-dessus de la rainure (SL2), dans la région de la lamelle (L), dans la surface (OB) du premier composant (S1, S2,S3). (Figures 4a, 4b) .

5. Procédé suivant la revendication 1, selon lequel dans le cas du premier composant (S2), le fond de la rainure (N), qui est en vis-à-vis de la face intérieure de la rainure au-dessous de la lamelle (N), comporte une rainure longitudinale (SL1), et on aménage les bossages refoulés par estampage (P1) directement au-dessus de la rainure longitudinale (SL1), dans la région de la lamelle (L), dans la surface (OS) du premier composant (S2). (Figures 2a, 2b).

6. Procédé d'établissement d'une fixation, étanche du point de vue électromagnétique, entre deux composants métalliques (S1,B4), notamment pour la fixation d'une tôle de recouvrement sur un rail de support d'un porte-modules blindé destiné à des modules électroniques,
selon lequel
a) le premier composant (S1) comporte une rainure (N) dans sa face supérieure (OS),
b) le second composant (B4) comporte une partie d'enfichage en forme de couteau (EB), dans laquelle on forme, de manière à ce qu'ils dépassent, des bossages refoulés par estampage (P2) , et
c) après enfichage de la partie d'enfichage (EB) du second composant (B4) dans la rainure (N) du premier composant (S1), on effectue la fixation des deux composants (S1,B4) par coincement des parties refoulées par estampage (P2) à l'intérieur de la rainure (N). (Figures 5a et 5b).

7. Procédé suivant la revendication 6, selon lequel la rainure (N) a un rétrécissement ou une largeur plus petite au bord de la face supérieure (OS) du premier composant (S1) qu'en son intérieur.

8. Procédé suivant la revendication 6 ou 7, selon lequel la rainure (N) a au moins un biseau d'insertion (E) directement au bord de la face supérieure (OS) du premier composant (S1).

9. Porte-module blindé destiné à la fixation de composants électroniques, notamment de plaquettes à circuits imprimés, comprenant
a) un premier composant métallique (S1,S2 ou S3), notamment un rail de support, qui comporte, au bord d'une face supérieure (OS), une rainure (N), qui est recouverte par une lamelle (L) de préférence sous la forme d'un prolongement de la face supérieure (OS) du composant (S1, S2 ou S3), et
b) un second composant métallique (B1,B2 ou B3), notamment une tôle de recouvrement, qui comporte une partie d'enfichage (EB) en forme de couteau, et
c) la fixation, étanche du point de vue électromagnétique, des deux composants (S1,S2 ou S3 avec B1, B2 ou B3) s'effectue au moyen de bossages refoulés par estampage (P1), qui sont aménagés dans la région de la lamelle (L), dans la face supérieure (OS) du premier composant (S1,S2 ou S3), après enfichage de la partie d'enfichage (EB) du second composant (B1,B2 ou B3) dans la rainure (N).

10. Porte-modules blindé destiné à la fixation de modules électriques, notamment de plaquettes à circuits imprimés, comportant
a) un premier composant métallique (S1), notamment un rail de support, qui comporte une rainure (N) aménagée dans sa face supérieure, et
b) un second composant métallique (B4), notamment une tôle de recouvrement, qui comporte une partie d'enfichage (EB) en forme de couteau comportant des bossages saillants refoulés par estampage, et
c) la fixation, étanche du point de vue électromagnétique, des deux composants (S1,B4) s'effectue après enfichage de la partie d'enfichage (EB) du second composant (B4) dans la rainure (N) du premier composant (S1) par coincement des bossages refoulés par estampage (P2) à l'intérieur de la rainure (N). (Figures Sa et 5b).
